# EUROPEAN PATENT SPECIFICATION

(11) **EP 4 505 000 B1**
(45) Date of publication and mention of the grant of the patent: **24.12.2025**
(21) Application number: 23724015.5
(22) Date of filing: 04.04.2023
(51) Int. Cl.: C25D 3/38, H01L 21/288, H01L 21/768

(54) **ELECTROLYTE COMPRISING AN ACCELERATOR AGENT FOR BOTTOM-UP COPPER ELECTROPLATING**
ELEKTROLYT MIT EINEM BESCHLEUNIGER FÜR KUPFERGALVANISIERUNG VON UNTEN NACH OBEN
ÉLECTROLYTE COMPRENANT UN AGENT ACCÉLÉRATEUR POUR LE DÉPÔT ÉLECTROLYTIQUE DE CUIVRE DE BAS EN HAUT

(30) Priority: 05.04.2022 US 202263327457 P
(43) Date of publication of application: 12.02.2025
(73) Proprietor: MacDermid Enthone Inc., Waterbury, CT 06702 (US)
(72) Inventor: BERTHON, Hermine, Marie, 86380 Chabournay (FR); THIAM, Mikailou, 94240 L'Hay-les-Roses (FR); CAILLARD, Louis, 94230 Cachan (FR); KIM, Yeeseul, 91190 Gif-sur-Yvette (FR)
(74) Representative: Novagraaf Group
(86) International application number: PCT/IB2023/000201
(87) International publication number: WO 2023/194802

(56) References cited:
- EP-A2- 0 440 027
- FR-A1- 3 112 559
- US-A1- 2015 159 291

## Description

### FIELD OF THE INVENTION

The present invention relates to a copper electrodeposition solution for electroplating copper on metal surfaces. The solution can be used in a method for filling etched lines and holes in semiconductor substrates for fabricating interconnects in integrated circuits.

### BACKGROUND OF THE INVENTION

The demand for semi-conductor integrated circuit (IC) devices such as computer chips with high circuit speed and high circuit density requires the miniaturization of feature sizes. The trend to smaller device sizes and increased circuit density requires decreasing the dimensions of interconnect features and increasing their density. An interconnect feature is a feature such as a via or trench that is formed in a dielectric substrate which is then filled with metal, typically copper, to yield an electrically conductive interconnect. Copper, having better conductivity than any metal except silver, is the metal of choice because copper metallization allows for smaller features and uses less energy to pass electricity. In damascene processing, interconnect features of semiconductor IC devices are metallized using electrolytic copper deposition.

In recent years, new copper plating processes have been evaluated to address both miniaturization and integration requirements for advanced and portable electronic products.

Miniaturization of devices such as high-power computer chips with high storage density and low dissipation also requires lower dimensions for interconnects such as through silicon vias (TSVs). Technology semiconductor device fabrication nodes lower than 30 nm are consequently developed for chip manufacturing.

Interconnects form a network of electrically conducting copper metal for connecting various electrical devices within a dielectric material, typically silicon oxide. Fabricating interconnects involves etching trenches in a dielectric material layer, and etching blind vias used to connect two different dielectric material layer. The formed cavities are then filled with copper.

There is a need to increase production rate without any detrimental defects, especially voids or seam lines in copper interconnects which tend to increase the resistance or even cause a break in the copper conducting lines.

It has been discovered that many of the known electrolytes cannot be used at the industrial scale for filling trenches and vias having low opening dimensions and/or high depth dimensions. That is, defects in the copper volume, including voids, may form during copper filling with conventional acidic copper ion baths.

During interconnect manufacturing, copper plating technology is usually used to fill in the patterns with copper in order to form the conductive lines. Copper electroplating may also be performed when a very thin copper layer (called copper seed layers) is required on the pattern surface before the copper filling step. However, electrolytes that work for copper seed plating cannot generally be adapted for copper filling plating.

Solutions containing bipyridine and pyridine are described, for example, in U.S. Pat. No. 9,133,560 to Daviot et al*.* These solutions were designed for making copper seed layers on substrates having high resistivity. However, it was found that the aqueous copper (II) ions solutions described therein cannot be used to fill in trenches with copper, especially because copper plating speed is far too low.

There remains a need in the art for improved copper electrodeposition compositions that can avoid detrimental defects in copper interconnects, especially voids or seam lines which tend to increase the resistance or even cause a break.

In addition, there remains a need in the art for electrolytic plating solutions and electrodeposition methods for defect-free copper filling of recessed features according to a bottom-up filling mechanism.

US 2015/0159291 A1 discloses an electrolyte composition for depositing copper on metal substrates. The composition contains a combination of two aromatic amines and an electrochemically inert cation.

FR 3 112 559 A1 discloses an electrolyte for depositing a copper barrier layer in a Damascene process. The electrolyte has a pH greater than 6.0 and comprises copper ions; manganese or zinc ions; and ethylenediamine which complexes the copper.

EP 0 440 027 A1 discloses the use of an additive for acid copper plating bath which is chosen based on criteria of creating a shift in the charge transfer overpotential of the bath; or alternatively, creating a differential overpotential between the surface of a high aspect ratio circuit board and the recesses of such boards.

### SUMMARY OF THE INVENTION

According to a first aspect, the present invention provides an electrolyte for electrodepositing copper on a conductive substrate, according to claim 1.

According to a second aspect, the present invention relates to an electrochemical copper deposition process on a substrate comprising at least one conductive exposed surface, according to claim 10. The process comprises the steps of:
- bringing the conductive exposed surface into contact with the electrolyte for copper electrodeposition of the invention, and
- polarizing the conductive exposed surface with a cathodic electric current and allowing the electrodeposition of copper onto the conductive exposed surface for a time sufficient to form a copper deposit.

It has been surprisingly found that the use of dithiodiglycolic acid, thioglycolic acid, thiourea and thiocyanic acid in the electrolyte provides an accelerator effect that is considerably higher than what has been observed using accelerators of the prior art such as thiodiglycolic acid. Such accelerator effect is a key phenomenon for void free filling of damascene structures through bottom up mechanism.

Certain more specific aspects of the invention are set out in the dependent claims.

### DETAILED DESCRIPTION

The inventors of the present invention have surprisingly discovered that the addition of specific molecules to the copper electrodeposition composition can improved quality of the bottom-up filling by accelerating copper deposit.

As used herein, the term "accelerator" refers to an organic molecule that is selected from the group consisting of dithiodiglycolic acid, thioglycolic acid, thiourea, ammonium thiocyanate and thiocyanic acid. According to a particular embodiment, when the electrolyte is used for filling cavities via an electrochemical process, the accelerator improves the quality of the copper deposit in the cavities.

As used herein, the term "electrodeposition" refers to a method that makes it possible to cover a surface of a substrate with a metallic or organometallic coating, in which the substrate is polarized electrically and brought into contact with a liquid containing precursors of said metallic or organometallic coating (called electrolyte), so as to form said coating. Electrodeposition is performed for example by passing a current between the substrate to be coated constituting one electrode (cathode in the case of a metallic coating) and a second electrode (the anode) in a bath containing a source of precursors of the coating material (for example metal ions in the case of a metallic coating) and optionally various agents intended to improve the properties of the coating formed (evenness and fineness of the deposit, resistivity, etc.), optionally in the presence of a reference electrode. By international convention, the current and voltage applied to the substrate of interest, i.e. to the cathode of the electrochemical circuit, are negative. Throughout this text, when these currents and voltages are mentioned with a positive value, it is implicit that this value represents the absolute value of said current or of said voltage.

As used herein, the term "electrolyte" refers to a liquid containing precursors of a metallic coating used in an electrodeposition process as defined above.

As used herein, the term "opening dimension" of patterns such as vias or trenches, refers to an average diameter or average width of the patterns hollowed out beforehand in the dielectric substrate and covered with a metal seed layer, wherein the average diameter is measured at the pattern opening. These dimensions are measured at the surface of the dielectric material because the average diameter of the trenches at bottom thereof, or average diameter of blind vias at bottom thereof may be different from the opening dimension especially in the case that the pattern walls are not perpendicular to the substrate surface.

As used herein, the term "continuous filling" refers to either a mass of void-free copper resulting from optimal filling of the entire empty volume of hollowed patterns (also called cavity or recessed feature) that has been etched in a dielectric substrate. According to the invention, the optimal filling is obtained from the bottom to the opening of the patterns ("bottom-up"). In the prior art, holes or voids may be observed in a copper deposit between the sidewalls of the patterns and the copper deposit ("sidewall voids"). Voids equidistant from the side walls of the patterns in the form of holes or lines ("seams") may also be observed, generally because copper growth speed at the bottom of the patterns can be slower than copper growth speed on the sidewalls and at the opening of the patterns. These voids may be quantified on transverse sections of the copper deposit that are observed by transmission electron microscopy (TEM) with a magnification being between 100,000 and 150,000. The continuous copper deposit of the invention preferably has an average volume percentage of voids below 10 vol.%, preferably less than or equal to 5 vol.%. The average percentage of voids is preferably 0 vol.%. The voids may be located in the copper deposit itself. In some cases, such a void forms in the upper zone of the cavity because copper growth speed is higher in the pattern opening zone, than in the pattern bottom zone.

As used herein, the term "about" refers to a measurable value such as a parameter, an amount, a temporal duration, and the like and is meant to include variations of +/-15% or less, preferably variations of +/-10% or less, more preferably variations of +/-5% or less, even more preferably variations of +/-1% or less, and still more preferably variations of +/-0.1% or less of and from the particularly recited value, in so far as such variations are appropriate to perform in the invention described herein. Furthermore, it is also to be understood that the value to which the modifier "about" refers is itself specifically disclosed herein.

As used herein, spatially relative terms, such as "beneath," "below," "lower," "above," "upper," and the like, are used for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly. It is further understood that the terms "front" and "back" are not intended to be limiting and are intended to be interchangeable where appropriate.

As used herein the term "substantially-free" or "essentially-free" if not otherwise defined herein for a particular element or compound means that a given element or compound is not detectable by ordinary analytical means that are well known to those skilled in the art of metal plating for bath analysis. Such methods typically include atomic absorption spectrometry, titration, UV-Vis analysis, secondary ion mass spectrometry, and other commonly available analytically methods.

As used herein, the terms "comprises" and/or "comprising," specify the presence of stated features, integers, steps, operations, elements, and/or components, but do not preclude the presence or addition of one or more other features, integers, steps, operations, elements, components, and/or groups thereof.As used herein, the term "between... and..." excludes the cut-off values, whereas the term "from...to..." includes the recited lower and upper limits.

In a first embodiment, the present invention relates generally to an electrolyte having a pH being from 8.5 to 9.5, that is intended for electrodeposition of copper on a metal substrate, said electrolyte comprising, in an aqueous solution,
- from 0.4 to 50 mM of copper (II) ions,
- from 0.4 to 50 mM of a mixture consisting of a first aromatic amine, a second aromatic amine and a complexing agent for copper (II) ions, and
- at least one accelerator selected in the group consisting of dithiodiglycolic acid, thioglycolic acid, thiourea, ammonium thiocyanate, thiocyanic acid, and combinations thereof.

A complexing constant (constant K) of a complex consisting of copper (II) ions and the complexing agent differ from a complexing constant of a copper (II) complexed with a ligand selected from the group consisting of a first aromatic amine, a second aromatic amine, and mixtures thereof, by a factor being higher than 10, and preferably higher than 100.

Copper ions are preferably in complex form with the first aromatic amine, with the second aromatic amine and with the complexing agent.

The electrolyte comprises at least one first copper (II) ion complex selected from the group consisting of:
- a complex of copper (II) ions with first aromatic amine and second aromatic amine;
- a combination of a complex of copper (II) ions with first aromatic amine and a complex of copper (II) ions with second aromatic amine;
- a combination of a complex of copper (II) ions with first aromatic amine and a complex of copper (II) ions with first aromatic amine and second aromatic amine;
- a combination of a complex of copper (II) ions with second aromatic amine and a complex of copper (II) ions with first aromatic amine and second aromatic amine; and
- a combination of a complex of copper (II) ions with 2,2'-bipyridine, a complex of copper (II) ions with second aromatic amine, and a complex of copper (II) ions with first aromatic amine and second aromatic amine.

The electrolyte preferably comprises at least one second copper (II) ion complex that includes the complexing agent as described herein.

The complex of copper (II) ions with the complexing agent may have a logarithmic complexing constant (log K) that is higher than 7.

The molar ratio between the first aromatic amine concentration and the second aromatic amine concentration can be from 1/2 to 2/1 and more preferably from 4/5 to 6/5, and the molar ratio between the first amine concentration and the complexing agent concentration can be from 1/4 to 4/1, for example from 1/3 to 3/1, or from 1/2 to 2/1 ± 10%.

A complex of copper (II) ions can include the first aromatic amine alone, the second aromatic amine alone, or both aromatic amines. In the electrolyte solution, molar concentration of a complex of copper (II) ions including the first aromatic amine and the second aromatic amine is preferably higher than molar concentration of a copper complex including the first aromatic amine, and higher than molar concentration of a copper complex including the second aromatic amine. More preferably, the electrolyte contains no copper complex including the first aromatic amine alone and no copper complex including the second aromatic amine alone.

In one preferred embodiment, the first amine can be 2,2'-bipyridine, and the second amine can be imidazole.

In general, the electrodeposition composition according to the invention comprises a source of cupric ions Cu²⁺ (copper (II) in the form of a salt). Advantageously, the source of copper (II) ions used for preparing the electrolyte is a copper (II) salt such as copper (II) sulfate, a copper alkyl sulfonate, such as copper methane sulfonate, a copper halide, such as copper (II) chloride, copper (II) nitrate, copper (II) citrate, copper (II) oxide, copper (II) carbonate, or copper (II) acetate. In one embodiment, the source of copper (II) ions is copper (II) sulfate, and more preferably copper (II) sulfate pentahydrate.

According to a particular feature, copper (II) ions in a complex form is present in the electrodeposition composition at a concentration between 0.4 and 50 mM, preferably between 0.4 and 40 mM, for example between 1.0 and 25 mM, between 4.0 and 15 mM.

The electrolyte advantageously comprises a first complex of copper (II) ions comprising one 2,2'-bipyridine ligand and one imidazole ligand, and a second complex of copper (II) ions with the complexing agent for copper.

In the electrolyte, the molar ratio between the first complex of copper (II) and the second complex of copper (II) can be advantageously selected as a function of the complexing agent chemical formula, and of the pattern dimensions (such as opening dimension and depth). The molar ratio between the first complex of copper (II) and the second complex of copper (II) can be from 0.1 to 4.0, for example from 0.2 to 3.0, and preferably from 0.5 to 1.5.

The ratio between 2,2'-bipyridine molar concentration and imidazole molar concentration is preferably from 1:2 to 2:1, more preferably from 4:5 to 6:5, and still more preferably from 0.95 to 1.05.

The ratio of molar concentration of complexing agent to molar concentration of copper (II) ions is preferably between 0.15 and 6.0, more preferably between 0.2 to 4.0 or from 0.3 and 2.5, for example from 0.5 to 2.0.

The electrolyte of the invention also comprises at least one accelerator selected in the group consisting of dithiodiglycolic acid, thioglycolic acid, thiourea, ammonium thiocyanate, thiocyanic acid, and combinations of the foregoing. In one embodiment, the electrolyte is at least substantially free of thiodiglycolic acid.

The concentration of the at least one accelerator can be from 0.05 ppm to 200 ppm, advantageously from 0.1 ppm to 20 ppm, depending on the chosen accelerator.

The accelerator that is used according to the invention can provide an improved accelerating effect when it is used in a mass concentration or in a molar concentration that is equal or lower than the mass concentration of accelerators such as thiodiglycolic acid used in compositions of the prior art such as described in U.S. Pat. No. 10,883,185. By an "improved accelerating effect" what is meant is that there is a lower percentage of voids in the copper deposit, or a higher filling speed of cavities as compared with the use of the accelerators of the prior art.

Without wishing to be bound by theory, it is believed that the reason that the accelerating effects of the compounds described herein are greater than that of thiodiglycolic acid is due to the greater mass percent sulfur in the compounds. In an alkaline environment it has been observed that species with accelerating capabilities that contain higher mass percent sulfur (of total compound mass) have a better bottom-up effect. This trend is not observed in acidic copper electroplating. In one embodiment, the accelerator is dithiodiglycolic acid, which is preferably used at a concentration within the range of from 2 ppm to 20 ppm, more preferably from 5 ppm to 15 ppm.

In one embodiment, the accelerator is thioglycolic acid, which is preferably used at a concentration within the range of from 0.1 to 20 ppm more preferably from 1 ppm to 10 ppm.

In one embodiment, the accelerator is thiourea, which is preferably used at a concentration within the range of from 0.01 to 5 ppm, more preferably from 0.1 to 2 ppm.

In one embodiment, the accelerator is ammonium thiocyanate, which is preferably used at a concentration within the range of form 0.01 to 5 ppm, more preferably from 0.1 ppm to 2 ppm.

In one embodiment, the accelerator is thiocyanic acid, which is preferably used at a concentration within the range of form 0.01 to 5 ppm, more preferably from 0.1 ppm to 2 ppm.

The complexing agent for copper (II) that is part of the electrolyte of the invention or part of the process of the invention for preparing the electrolyte can be selected from the group consisting of citric acid, tartaric acid, phenanthroline, ethylenediaminetetraacetic acid (EDTA), N-(hydroxyethyl)-ethylenediaminetriacetic acid (HEDTA), ethylenediamine, 1,6 diaminocyclohexane, diethylene-triamine, triethylene-tetramine, N,N,N,N-tetramethyl-ethylenediamine, N,N-Bis(2-hydroxyethyl)ethylenediamine, N,N,N,N-tetrakis(2-hydroxyethyl)ethylenediamine, glycine, 2-amino-ethyl-phosphonic acid, salicylic acid, salicylhydroxamic acid, catechol, 1,2-dihydroxybenzene-4-sulfonic acid, acetylacetone, acetylacetonate, dimethylglyoxime and 1,3-diamino-propane. The complexing agent can be used in any of its acidic or basic forms when complexed with copper.

In one particular embodiment, the complexing agent is ethylenediamine.

In another particular embodiment, the complexing agent is tartrate ion.

The electrolyte of the invention may advantageously be devoid of polymeric suppressors such as polyethylene glycols. In addition, previously, a source of chlorine ions is generally added to the electrolyte to act in synergy with a polymeric suppressor. However, in the context of the present invention, it was discovered that it is not necessary to add chlorine ions to guarantee the efficacy of the solution. Therefore, the electrolyte of the invention preferably comprises less than 50 ppm of chlorine ions. More preferably, the electrolyte is at least substantially free of chlorine ions.

While surfactants were generally required in electrolytes of the prior art for improving the wettability of the surface of a barrier material to be coated with copper, according to the invention, it is not necessary to incorporate surfactants in the electrolyte. Therefore, the electrolyte of the present invention may be at substantially free of any surfactant or wetting agent.

The electrolyte may comprise a leveller and/or a brightener as known in the art. However, the use of a leveller and/or a brightener is not required and a good result may be achieved even in the absence of a leveller and/or a brightener.

The pH of the electrolyte is selected to be above 8.5. This is all the more surprising as the electrolytes of the prior art used for filling cavities generally have a far lower pH to guarantee sufficient conductivity of the solution owing to the presence of H⁺ ions, and in consequence, to obtain adequate kinetics. The pH of the electrolyte of the invention is preferably between 9.0 and 9.5, and even more preferably 9.2 ± 10 %. The pH of the electrolyte may be adjusted to the desired range using one or more pH-modifying compounds, including, for example, a tetra-alkylammonium salt such as a tetra-methylammonium salt or a tetra-ethylammonium salt. In one embodiment, the pH adjuster comprises tetra-methylammonium hydroxide or tetra-ethylammonium hydroxide.

The concentration of the copper (II) ions is between 0.4 and 50 mM, for example between 0.4 and 40 mM, the concentration of 2,2'-bipyridine is between 0.4 and 40 mM, and the concentration of complexing agent is between 1 to 100 mM.

In the case that the complexing agent is ethylenediamine, the concentration of copper (II) ions can be between 4 and 20 mM, the concentration of the mixture consisting of 2,2'-bipyridine and imidazole can be between 5 and 20 mM and the concentration of complexing agent can be between 1 and 60 mM.

In the case that the complexing agent is tartrate ion, the molar concentration of copper (II) ions can be from 4 to 20 mM, the molar concentration of 2,2'-bipyridine and imidazole mixture can be from 5 to 20 mM and the molar concentration of complexing agent for copper (II) ions can be from 3 to 50 mM.

In the electrolyte, the first aromatic amine concentration (such as 2,2'-bipyridine concentration) preferably represents from 0.05 to 1 molar equivalent, more preferably from 0.1 to 0.8 molar equivalent, more preferably from 0.4 to 0.7 molar equivalent of the concentration of copper (II) ions.

In the electrolyte, the second aromatic amine concentration (such as imidazole concentration) preferably represents from 0.05 to 1 molar equivalent, more preferably from 0.1 to 0.8 molar equivalent, more preferably from 0.4 to 0.7 molar equivalent of the concentration of copper (II) ions.

The electrolyte may be obtained by mixing:
- a first solution comprising a first copper (II) ion complex with a second solution comprising a second copper (II) ion complex, said first solution resulting from mixing copper (II) ions, 2,2'-bipyridine, and imidazole, wherein a molar ratio between a 2,2'-bipyridine concentration and an imidazole concentration is in the range from 4/1 to 1/4, and
- a second solution resulting from mixing copper (II) ions with the complexing molecule.

A concentration of the complexing molecule in the second solution can be from 0.15 to 6.0 molar equivalent of a concentration of copper (II) ions in the second solution. A ratio between a molar concentration of copper (II) ions and a molar concentration resulting from the sum of the imidazole molar concentration and the 2,2'-bipyridine molar concentration can be from 1/5 to 10/1 in the first solution.

Mixing the first solution and the second solution can be performed with a volume ratio between the second solution and the first solution being selected to be between 5 vol. % to 35 vol. %, more preferably between 10 vo. % and 25 vol. %.

Also provided herein is a process for preparing one of the electrolytes as described above.

Such a process may comprise a step of preparing a first solution of a copper (II) complex with 2,2'-bipyridine and imidazole, a step of preparing a second solution of a copper (II) complex with a complexing agent for copper (II) ions that forms a complex with copper (II) ions having a logarithmic complexing constant (log K) that is higher than 7, a step of mixing the first solution and the second solution in a particular volume ratio, and a step of obtaining the electrolyte comprising at least two complexes: a complex of copper (II) with 2,2'-bipyridine and imidazole, and a complex of copper (II) with the complexing agent.

Another process may comprise a step of preparing a first solution comprising copper (II) ions, the first aromatic amine, and the second aromatic amine, so as to advantageously prepare a complex of copper (II) ions with the first aromatic amine and/or the second aromatic amine, a step of preparing a second solution comprising copper (II) ions and the complexing agent, so as to advantageously prepare a complex of copper (II) ions with the complexing agent, and a step of mixing the first and the second solution.

In the first solution molar concentration of copper (II) ions is preferably between 0.3 to and 60 mM or from 0.8 to 50 mM, preferably between 1 and 10 mM, more preferably between 3 and 9 mM.

In the first solution, the first aromatic amine concentration (such as 2,2'-bipyridine concentration) and the copper (II) molar concentration are preferably equal to the second aromatic amine concentration (such as imidazole concentration) within a ± 10% possible variation range.

The pH of the first solution may optionally be adjusted with a base or an acid known by a person skilled in the art after mixing the aromatic amines with the copper (II) ions. A pH adjuster may be, for example, sulfuric acid or a tetra-alkylammonium salt such as a tetra-methylammonium salt or a tetra-ethylammonium salt (e.g., tetra-methylammonium hydroxide or tetra-ethylammonium hydroxide). The first solution may have a pH value between 8 and 10, for example from 8.85 to 9.25.

The pH of the first solution, once adjusted, may optionally be stabilized in the aforementioned pH range by means of a buffer as is known by those skilled in the art.

In the second solution, molar concentration of copper (II) ions is preferably between 30 to and 100 mM or from 40 to 80 mM, preferably between 60 and 70 mM.

In the second solution, the complexing agent concentration is generally chosen with relation to the copper (II) concentration in the electrolyte, in order to form a significant amount of a complex of copper with the complexing agent. The complexing agent concentration preferably represents from 0.5 to 3 molar equivalent of the concentration of copper (II) ions.

In the case that the complexing agent is tartrate, the complexing agent concentration preferably represents from 0.5 to 2 molar equivalent, more preferably from 0.65 to 1.25 molar equivalents, more preferably from 0.75 to 1.15 molar equivalent, and still more equivalent 0.95 to 1.05 molar equivalent of the concentration of copper (II) ions. The pH of the second solution may optionally be adjusted with a base or an acid as known by one skilled in the art after mixing the aromatic amines with the copper (II) ions.

The second solution may comprise a pH adjuster in order to have a pH value between 7 and 11. The pH is preferably adjusted in order to form a complex of copper ions with the complexing agent.

The pH of the second solution, once adjusted, may optionally be stabilized in the aforementioned pH range by means of a buffer as known by one skilled in the art.

The volume ratio between the second solution and the first solution can be from 5 vol. % to 35 vol. %, more preferably between 10 vol. % and 25 vol. %.

Additional ingredients can be incorporated into the first solution and/or into the second solution before mixing the two.

Alternatively, additional ingredients can be added in a further step following the step of mixing the first solution and the second solution.

Although there is in principle no restriction about the solvent (provided that it sufficiently solubilizes the active species of the solution and does not interfere with electrodeposition), water will be preferred as a solvent for the electrolyte, for the first solution and for the second solution. According to one embodiment, the solvent essentially comprises water, i.e. comprises more than 90 vol.%.

The first solution and the second solution can be prepared by dissolution in a solvent of a salt or hydrate thereof that is selected from the group consisting of copper (II) sulfate, copper (II) chloride, copper (II) nitrate, copper (II) acetate, preferably copper (II) sulfate, and more preferably copper (II) sulfate pentahydrate.

The invention also relates to an electrochemical copper deposition process on a substrate comprising at least one conductive exposed surface, as defined in claim 10. The process comprises the steps of:
- bringing the conductive exposed surface into contact with an electrolyte of the invention, and
- polarizing the conductive exposed surface with a cathodic electric current and allowing the electrodeposition of copper onto the conductive exposed surface for a time sufficient to form a copper deposit.

The cavities (also known as patterns) may have a mean diameter or mean width at their opening being from 10 to 30 nm, and a depth being from 1 to 150 microns.

In one embodiment, the process of the present invention is useful for filling patterns that have been hollowed-out in a dielectric substrate, the patterns having a dimension less than 45 nm, preferably less than 25 nm, and a form factor higher than 2:1, preferably higher than 3:1.

In one preferred embodiment, the patterns have an opening dimension less than 25 nm, and a form factor higher than 3:1.

The process may be an electrochemical process for copper filling of patterns that are hollowed-out in a dielectric substrate, and have at least one exposed surface of a metal seed layer, wherein said patterns have an opening dimension that is less than 45 nm and a form factor that is higher than 2, said process comprising the steps of:
- bringing the exposed surface into contact with one of the electrolytes as described herein, and
- polarizing the exposed surface with a cathodic electric current and allowing the electrodeposition of copper onto the exposed surface, for a time sufficient to completely fill patterns with a copper deposit that comprises no void.

All the features that have been described in relation to the electrolytes and a process for preparing the electrolytes of the invention apply to the electrodeposition process.

The electrolyte is used by applying an electric current. It is not indicated in an electroless process, and for this reason does not contain a reducing agent of copper (II) oxide, such as dimethylamine borane or hypophosphorous acid.

The electrochemical process of the invention has the advantage of providing a copper filling speed that is at least twice or at least three times higher than a copper filing speed that is obtained with an electrochemical process that is identical with the exception that the electrolyte comprises no complex of copper (II) ions with the complexing agent as described herein.

In this embodiment, the patterns have preferably an opening dimension lower than 25 nm and a form factor that is higher than 3.

The copper filling speed depends on the time that is necessary to fill in the entire volume of the trenches or vias. Copper filling rate if the volume percentage of the pattern cavity that is filled with copper at the end of a predetermined time, for example 1 minute or 3 minutes. Copper filling speed can be expressed as the time that is necessary to fill the entire volume of a predetermined pattern cavity.

The invention also describes a semiconductor manufacturing process that is analogous to a copper damascene system or a copper dual damascene system.

A main first step comprises etching a dielectric substrate. The architecture is comprised of a combination of the aforementioned patterns that can be trenches and vias. Next, a diffusion barrier layer is laid over a free surface of the dielectric substrate comprising the etched patterns, in order to prevent diffusion of the subsequently applied copper layer into the substrate's junctions.

The electrochemical deposition process of the invention may comprise a step of forming a thin metal seed layer made of copper (Cu), cobalt (Co) or ruthenium (Ru), prior to copper filing step. The metal seed layer may comprise at least two materials selected in the group consisting of copper (Cu), cobalt (Co) or ruthenium (Ru). In a particular embodiment, the metal seed layer comprises a ruthenium layer and a copper layer. In another embodiment, the metal seed layer comprises a cobalt layer and a copper layer, the cobalt layer being layered on a diffusion barrier layer.

This thin metal seed layer can be deposited onto a diffusion barrier layer using a technique known from one skilled in the art, such as chemical vapor deposition (CVD), physical vapor deposition (PVD), atomic layer deposition (ALD), electroless or electrochemical deposition.

Consequently, the process of the invention may comprise a step of forming the metal seed layer using chemical vapor deposition (CVD), physical vapor deposition (PVD), atomic layer deposition (ALD), electroless deposition or electrochemical deposition, on the condition that electroless deposition and electrolytic deposition both use an electrolyte that is different from the as described with regard to the first embodiment of the invention.

In one preferred embodiment of the invention, the metal seed layer is formed via PVD route.

The metal seed layer has preferably a thickness being between 0.5 and 20 nm, preferably between 1 to 10 nm, for example between 2 and 5 nm. Such thickness values are preferably measured on the inside walls of the patterns. Indeed, the metal seed layer may have a different thickness value on the dielectric substrate field; at the pattern opening, and on the pattern sidewalls and on the pattern bottom.

The diffusion barrier layer may comprise at least one material selected from the group consisting of tantalum (Ta), titanium (Ti), tantalum nitride (TaN), titanium nitride (TiN), manganese (Mn) and tungsten (W). The thickness of the diffusion barrier layer is generally between 0.5 and 20 nm. This layer can be deposited using a technique known from one skilled in the art, such as chemical vapor deposition (CVD), physical vapor deposition (PVD) or atomic layer deposition (ALD). The diffusion barrier layer can be formed of two layers each of the layers being composed of one of the material as disclosed above.

According to an embodiment of the invention, the dielectric substrate is covered successively on the pattern sidewalls, on the pattern bottom and on the dielectric substrate field with at least two layers of two different materials forming a copper diffusion barrier as disclosed here above, and a conductive layer as describes above.

The method of the invention makes it possible to deposit copper in patterns with small opening dimension, notably trenches of very small width. Thus, the opening dimension of the patterns may be below an upper limit corresponding to a technology node selected from the group consisting of 45 nm, 40 nm, 35 nm, 30 nm, 25 nm, 20 nm, 15 nm and 10 nm. The opening dimension of the patterns may be selected in the group consisting of 45 nm, 32 nm, 22 nm, 14 nm, 10 nm, 7 nm and 5 nm. The patterns preferably have an opening dimension greater than or equal to 5 nm.

The form factor - expressed as the ratio between depth and opening dimension of the patterns - may vary from 2:1 to 20:1, for example from 3:1 to 10:1. The method according to the invention advantageously allows the void free deposition of copper in cavities having particularly high form factors, for example greater than 2:1, greater than 3:1, greater than 4:1, greater than 5:1, greater than 6:1, or even greater than 7:1 and above, preferably below 20:1 or below 15:1.

According to one particular embodiment, the patterns have an opening dimension being from 5 to 45 nm and a form factor being from 3:1 to 10:1.

The patterned surface of the conductive material comprises three main zones: (1) the field that is shared by all the cavities of patterns, (2) each cavity comprising sidewalls, and (3) a bottom.

During the deposition step, the surface of the cavity to be filled may be polarized, either in constant-current mode (fixed imposed current), or in constant-voltage mode (potential imposed and fixed, optionally relative to a reference electrode), or else in pulsed mode (in current or in voltage), or in ramp mode (in current or in voltage).

According to one embodiment of the invention, polarization of the surface of the cavity of the pattern is carried out in ramp mode, imposing a voltage from open circuit potential to - 1.5 V/SCE (Calomel saturated electrode) and from -1.5V/SCE (Calomel saturated electrode) to open circuit potential, with a scan rate equal to 5 mV/s.

The electrolytes according to the invention may be used following a procedure comprising an initial step of "hot entry," but particularly advantageously, they may also be used following a procedure comprising an initial step of "cold entry," during which the surface to be coated is brought into contact with the electrodeposition bath without electrical polarization, and maintained in this state for the desired time. Thus, according to a particular feature, the method according to the invention comprises, prior to electrodeposition, a step of "cold entry" during which the surface of the cavity to be filled is brought into contact with the electrodeposition composition according to the invention without electrical polarization, and optionally maintained in this state for at least 30 seconds.

The electrodeposition process according to the invention may be carried out at room temperature. Room temperature may be between 20 and 35°C. Therefore it is generally not necessary to heat the electrodeposition bath.

The method according to the invention provides copper deposits having excellent quality, for example without material defects such as seams or voids.

The invention finally relates to the semiconductor devices that are obtainable or that are obtained by the method that has just been described.

The invention is illustrated in more detail in the following examples. The temperature in each of the examples is room temperature unless indicated otherwise.

### Example 1 Comparative: Characterization of thiodiglycolic acid accelerating effect using copper electrochemical deposition

The impact of thiodiglycolic acid on copper deposition was characterized electrochemically. Deposition was performed using a composition containing copper (II) sulphate, 2,2'-bipyridine, imidazole, tetraethyl ammonium hydroxide and tartaric acid according to the teachings of U.S. Pat. No. 10,883,185.

### Material and equipment:

### Substrate:

The substrate used in this example is bulk pure cobalt with a thickness of 10 microns and a diameter of 5 mm.

### Electrolyte solution:

A first solution comprising 6.05 mM 2,2'-bipyridine, 6.05 mM imidazole and 6.05 mM CuSO₄(H₂O)₅ was prepared. A second solution comprising 65.4 mM tartaric acid and 64.1 mM CuSO₄(H₂O)₅ was prepared. The first and the second solution were mixed in a selected ratio, thiodiglycolic acid was added, and pH was adjusted so as to obtain the electrolyte solution.

In the resulting solution, the concentration of 2,2'-bipyridine was 5.44 mM and the concentration of imidazole was 5.44 mM. The concentration of CuSO₄(H₂O)₅ was equal to 11.85 mM and the concentration of tartrate was 6.54 mM. The concentration of thiodiglycolic acid was 25 ppm. The pH of the solution was adjusted with tetra-ethylammonium hydroxide and was equal to 9.2.

A 0.1 M K₂SO₄ salt support was added to neglect current migration contribution of Cᵤ²⁺.

### Equipment:

In this example, the electrolytic deposition equipment consisted of two parts: (1) the cell intended to contain the electrodeposition solution, equipped with a system for recirculation of fluid for controlling the hydrodynamics of the system, and (2) a rotating electrode equipped with a sample holder suitable for the size of the pieces used (4 cm x 4 cm).

The electrolytic deposition cell had two electrodes:
- Working electrode: rotating disk electrode of Co (D = 5 mm)
- Counter electrode : Platinum
- Reference electrode: Calomel saturated electrode (CSE)

Connectors provided electrical contact of the electrodes, which were connected by electrical leads to a potentiostat supplying up to 20 V or 2 A.

### Electric protocol:

Cathodic polarization from open circuit potential to -1.5 V/ECS and to -1.5 V/ECS to open circuit potential were performed. The scan rate was 5mV/s and the duration of the electrodeposition step was enough to measure the current response to assess the deposition rate.

### Reference:

A reference has been performed in order to evaluate the accelerator effect of thiodiglycolic acid. The protocol above was reproduced except that electrolyte solution contained no thiodiglycolic acid.

### Evaluation of the accelerator effect

Low current was observed during the first scan (from open circuit potential to -1.5 V/SCE), whereas, an hysteresis has been observed during the reverse scan (from -1.5 V/SCE to open circuit potential) once passivation of the surface of bulk cobalt had been broken.

Hysteresis was characterized by a ΔE, which is the difference of potential at which the deposition occurs when the passivation is intact (forward scan) and when it is degraded (reverse scan). The hysteresis surface area is a good indicator of the accelerator effect and can be extrapolated as a good indicator of the bottom up effect of the accelerator during the electroplating deposition process on a substrate that is etched with recessed features instead of a flat bulk cobalt substrate. A high ΔE means that accelerator makes copper reduction thermodynamically easier after that passivation has been broken.

### Obtained results:

The ratio between the prior art (the ΔE value of an electrolyte comprising thiodiglycolic acid) and the reference (the ΔE value of an electrolyte comprising no accelerator molecule) was found to be 1.1.

The same ratio was also measured using the hysteresis surface area as a parameter.

### Conclusion:

Comparable ΔE and hysteresis surface area were obtained with the use of thiodiglycolic acid as the accelerator and the reference. This means that thiodiglycolic acid has a very weak accelerator effect.

### Example 2 : Characterization of dithiodiglycolic acid accelerating effect using copper electrochemical deposition

Example 1 was reproduced except that in the electrolyte solution, thiodiglycolic acid was replaced by dithiodiglycolic acid at different concentrations (i.e., 1 to 30 ppm). The best ΔE was obtained at a concentration of 10 ppm, resulting in an increase in ΔE and hysteresis surface area by a factor of 3. This value is considerably higher than the one obtained in similar conditions in example 1, which means that dithiodiglycolic acid has a stronger accelerator impact than thiodiglycolic acid.

### Example 3: Characterization of thioglycolic acid accelerating effect using copper electrochemical deposition

Example 1 was reproduced except that in electrolyte solution thiodiglycolic acid was replaced by thioglycolic acid at different concentrations (e.g., from 1 to 30 ppm). The highest ΔE was obtained at a concentration of 5 ppm, resulting in an increase of ΔE by a factor of 2.5 and an increase of the hysteresis surface area by a factor of 2.5.

This value is considerably higher than the one obtained in similar conditions in example 1 which means that thioglycolic acid has a stronger accelerator impact than thiodiglycolic acid.

### Example 4 Comparative: Characterization of thiourea accelerating effect using copper electrochemical deposition

Example 1 was reproduced except that thiodiglycolic acid was replaced by thiourea having a concentration from 0.2 to 2 ppm, and the highest ΔE was obtained at a concentration of 1 ppm, resulting in an increase of ΔE and the hysteresis surface area by a factor being 1.5 on the basis of Reference.

### Example 5: Characterization of ammonium thiocyanate accelerating effect using copper electrochemical deposition

Example 1 was reproduced except that thiodiglycolic acid was replaced by ammonium thiocyanate at a concentration below 1 ppm, and the highest ΔE is obtained at a concentration of 0.5 ppm.

In this case, the ΔE and the hysteresis surface area have increased by a factor being 2.0 on the basis of Reference.

The results of Examples 1 to 5 are summarized in Table 1 here below. Concentration for each accelerator varies because of the varying stability and ΔE variation with concentration.

**Table 1**

| **Example** | **Accelerator** | **Concentration (ppm)** | **Hysteresis area ratio between example and reference (no measuring unit)** |
|---|---|---|---|
| 1 (Comparative) | Thiodiglycolic acid | 25 | 1.1 |
| 2 (Invention) | Dithiodiglycolic acid | 10 | 3.0 |
| 3 (Invention) | Thioglycolic acid | 5 | 2.5 |
| 4 (Invention) | Thiourea | 1 | 1.5 |
| 5 (Invention) | Ammonium thiocyanate | 0.5 | 2.0 |

The examples demonstrate that the use of one of the accelerators in the copper electrolyte produces a copper deposit that is free of voids, seams and other defects.

## Claims

1. An electrolyte for electrodepositing copper on a conductive substrate, wherein said electrolyte is an aqueous solution comprising:
- from 0.4 to 50 mM of copper (II) ions;
- from 0.4 to 50 mM of a mixture consisting of a first aromatic amine, a second aromatic amine and a complexing agent for copper (II) ions; and
- at least one accelerator selected from the group consisting of dithiodiglycolic acid, thioglycolic acid, thiourea, ammonium thiocyanate, thiocyanic acid, and combinations of the foregoing,
wherein the electrolyte has a pH of 8.5 to 9.5.

2. The electrolyte according to claim 1, wherein the first aromatic amine is 2,2'-bipyridine and the second aromatic amine is imidazole, preferably wherein the ratio between 2,2'-bipyridine molar concentration and imidazole molar concentration is from 1:2 to 2:1.

3. The electrolyte according to claim 1 or claim 2, wherein the complexing agent for copper (II) ions is a tartrate or ethylenediamine.

4. The electrolyte according to any one of the preceding claims, wherein the molar ratio between the first amine concentration and the complexing agent for copper (II) ions concentration is from 1/4 to 4/1, or from 1/3 to 3/1, or from 1/2 to 2/1 ± 10 %.

5. The electrolyte according to any one of the preceding claims, wherein the concentration of the at least one accelerator is from 0.05 ppm to 200 ppm, preferably from 0.1 ppm to 20 ppm.

6. The electrolyte according to claim 5, wherein the accelerator is dithiodiglycolic acid and is present at a concentration from 5 ppm to 15 ppm.

7. The electrolyte according to claim 5, wherein the accelerator is thioglycolic acid and is present at a concentration from 1 ppm to 10 ppm.

8. The electrolyte according to claim 5, wherein the accelerator is thiourea and is present at a concentration from 0.1 ppm to 2 ppm.

9. The electrolyte according to claim 5, wherein the accelerator is ammonium thiocyanate and is present at a concentration from 0.1 ppm to 2 ppm.

10. An electrochemical copper deposition process on a substrate comprising at least one conductive exposed surface, comprising the steps of:
- bringing the at least one conductive exposed surface into contact with an electrolyte according to any one of claims 1 to 9, and
- polarizing the at least one conductive exposed surface with a cathodic electric current and allowing the electrodeposition of copper onto the at least one conductive exposed surface for a time sufficient to form a copper deposit.

11. The electrochemical process according to claim 10, wherein the process further comprises a step of forming a metal seed layer on the at least one conductive exposed surface prior to forming the copper deposit, wherein the metal seed layer comprises a material selected from cobalt, copper, and ruthenium;
optionally wherein the metal seed layer is made of at least two materials selected from the group consisting of cobalt, copper, and ruthenium;
further optionally wherein the metal seed layer comprises a ruthenium layer and a copper layer; or the metal seed layer comprises a cobalt layer and a copper layer, the cobalt layer being layered on a diffusion barrier layer.

12. The electrochemical process as claimed in claim 11, wherein the metal seed layer has a thickness that is from 1 nm to 10 nm.

13. The electrochemical process according to claim 10, wherein the conductive exposed surface is a surface of patterns formed in a dielectric substrate.

14. The electrochemical process according to any of claims 11 to 13, wherein polarizing the conductive exposed surface is conducted for a time sufficient to completely fill the patterns with a copper deposit, wherein the average percentage of voids is 0 vol.%.

15. The electrochemical process according to claim 13 or claim 14, wherein patterns have an opening dimension that is from 5 to 45 nm and a form factor that is higher than 2, preferably from 3 to 10, more preferably from 4 to 10.

## Patentansprüche

1. Elektrolyt zum galvanischen Abscheiden von Kupfer auf einem leitfähigen Substrat, wobei der Elektrolyt eine wässrige Lösung ist, umfassend:
- von zu 0,4 bis 50 mM Kupfer(II)-Ionen;
- von zu 0,4 bis 50 mM eine Mischung bestehend aus einem ersten aromatischen Amin, einem zweiten aromatischen Amin und einem Komplexbildner für Kupfer(II)-Ionen; und
- mindestens einen Beschleuniger, der aus der Gruppe ausgewählt ist, bestehend aus Dithiodiglykolsäure, Thioglykolsäure, Thioharnstoff, Ammoniumthiocyanat, Thiocyansäure und Kombinationen der Vorgenannten,
wobei der Elektrolyt einen pH-Wert von 8,5 bis 9,5 aufweist.

2. Elektrolyt nach Anspruch 1, wobei das erste aromatische Amin 2,2'-Bipyridin ist und das zweite aromatische Amin Imidazol ist, wobei das Verhältnis zwischen einer molaren Konzentration von 2,2'-Bipyridin und der molaren Konzentration von Imidazol vorzugsweise von 1 : 2 bis 2 : 1 beträgt.

3. Elektrolyt nach Anspruch 1 oder 2, wobei der Komplexbildner für Kupfer(II)-Ionen ein Tartrat oder Ethylendiamin ist.

4. Elektrolyt nach einem der vorstehenden Ansprüche, wobei das Molverhältnis zwischen der Konzentration des ersten Amins und der Konzentration des Komplexbildners für Kupfer(II)-Ionen von 1/4 bis 4/1 oder von 1/3 bis 3/1 oder von 1/2 bis 2/1 ± 10 % beträgt.

5. Elektrolyt nach einem der vorstehenden Ansprüche, wobei die Konzentration des mindestens einen Beschleunigers von 0,05 ppm bis 200 ppm, vorzugsweise von 0,1 ppm bis 20 ppm beträgt.

6. Elektrolyt nach Anspruch 5, wobei der Beschleuniger Dithiodiglykolsäure ist und in einer Konzentration von 5 ppm bis 15 ppm vorhanden ist.

7. Elektrolyt nach Anspruch 5, wobei der Beschleuniger Thioglykolsäure ist und in einer Konzentration von 1 ppm bis 10 ppm vorhanden ist.

8. Elektrolyt nach Anspruch 5, wobei der Beschleuniger Thioharnstoff ist und in einer Konzentration von 0,1 ppm bis 2 ppm vorhanden ist.

9. Elektrolyt nach Anspruch 5, wobei der Beschleuniger Ammoniumthiocyanat ist und in einer Konzentration von 0,1 ppm bis 2 ppm vorhanden ist.

10. Elektrochemisches Kupferabscheidungsverfahren auf einem Substrat, umfassend mindestens eine leitfähige freiliegende Oberfläche, umfassend die Schritte:
- Inkontaktbringen der mindestens einen leitfähigen freiliegenden Oberfläche mit einem Elektrolyten nach einem der Ansprüche 1 bis 9 und
- Polarisieren der mindestens einen leitfähigen freiliegenden Oberfläche mit einem kathodischen elektrischen Strom und Ermöglichen der galvanischen Abscheidung von Kupfer auf die mindestens eine leitfähige freiliegende Oberfläche für eine Zeit, die ausreicht, um eine Kupferabscheidung zu bilden.

11. Elektrochemisches Verfahren nach Anspruch 10, wobei das Verfahren ferner einen Schritt zum Bilden einer Metallkeimschicht auf der mindestens einen leitfähigen freiliegenden Oberfläche vor dem Bilden der Kupferabscheidung umfasst, wobei die Metallkeimschicht ein Material umfasst, das aus Kobalt, Kupfer und Ruthenium ausgewählt ist;
wobei die Metallkeimschicht optional aus mindestens zwei Materialien hergestellt ist, die aus der Gruppe ausgewählt sind, die aus Kobalt, Kupfer und Ruthenium besteht;
wobei die Metallkeimschicht ferner optional eine Rutheniumschicht und eine Kupferschicht umfasst; oder die Metallkeimschicht eine Kobaltschicht und eine Kupferschicht umfasst, wobei die Kobaltschicht auf eine Diffusionsbarriereschicht geschichtet ist.

12. Elektrochemisches Verfahren nach Anspruch 11, wobei die Metallkeimschicht eine Dicke von 1 nm bis 10 nm aufweist.

13. Elektrochemisches Verfahren nach Anspruch 10, wobei die leitfähige freiliegende Oberfläche eine Oberfläche aus Mustern ist, die in einem dielektrischen Substrat gebildet sind.

14. Elektrochemisches Verfahren nach einem der Ansprüche 11 bis 13, wobei das Polarisieren der leitfähigen freiliegenden Oberfläche für eine Zeit durchgeführt wird, die ausreicht, um die Muster vollständig mit einer Kupferabscheidung zu füllen, wobei der durchschnittliche Prozentsatz an Hohlräumen 0 Vol.-% beträgt.

15. Elektrochemisches Verfahren nach Anspruch 13 oder 14, wobei die Muster eine Öffnungsabmessung von 5 bis 45 nm und einen Formfaktor von mehr als 2, vorzugsweise von 3 bis 10, mehr bevorzugt von 4 bis 10 aufweisen.

## Revendications

1. Électrolyte pour l'électrodéposition de cuivre sur un substrat conducteur, dans lequel ledit électrolyte est une solution aqueuse comprenant :
- de 0,4 à 50 mM d'ions cuivre (II) ;
- de 0,4 à 50 mM d'un mélange constitué d'une première amine aromatique, d'une seconde amine aromatique et d'un agent complexant les ions cuivre (II) ; et
- au moins un accélérateur choisi dans le groupe constitué d'acide dithiodiglycolique, acide thioglycolique, thiourée, thiocyanate d'ammonium, acide thiocyanique et combinaisons de ceux-ci,
dans lequel l'électrolyte a un pH de 8,5 à 9,5.

2. Électrolyte selon la revendication 1, dans lequel la première amine aromatique est la 2,2'-bipyridine et la seconde amine aromatique est l'imidazole, de préférence dans lequel le rapport entre la concentration molaire de 2,2'-bipyridine et la concentration molaire d'imidazole va de 1:2 à 2:1.

3. Électrolyte selon la revendication 1 ou la revendication 2, dans lequel l'agent complexant les ions cuivre (II) est un tartrate ou l'éthylènediamine.

4. Électrolyte selon l'une quelconque des revendications précédentes, dans lequel le rapport molaire entre la concentration de la première amine et la concentration de l'agent complexant les ions cuivre (II) va de 1/4 à 4/1, ou de 1/3 à 3/1, ou de 1/2 à 2/1 ± 10 %.

5. Électrolyte selon l'une quelconque des revendications précédentes, dans lequel la concentration de l'au moins un accélérateur va de 0,05 ppm à 200 ppm, de préférence de 0,1 ppm à 20 ppm.

6. Électrolyte selon la revendication 5, dans lequel l'accélérateur est l'acide dithiodiglycolique et est présent à une concentration de 5 ppm à 15 ppm.

7. Électrolyte selon la revendication 5, dans lequel l'accélérateur est l'acide thioglycolique et est présent à une concentration de 1 ppm à 10 ppm.

8. Électrolyte selon la revendication 5, dans lequel l'accélérateur est la thiourée et est présent à une concentration de 0,1 ppm à 2 ppm.

9. Électrolyte selon la revendication 5, dans lequel l'accélérateur est le thiocyanate d'ammonium et est présent à une concentration de 0,1 ppm à 2 ppm.

10. Procédé de dépôt électrochimique de cuivre sur un substrat comprenant au moins une surface exposée conductrice, comprenant les étapes consistant à :
- mettre en contact l'au moins une surface exposée conductrice avec un électrolyte selon l'une quelconque des revendications 1 à 9, et
- polariser l'au moins une surface exposée conductrice avec un courant électrique cathodique et permettre l'électrodéposition de cuivre sur l'au moins une surface exposée conductrice pendant un temps suffisant pour former un dépôt de cuivre.

11. Procédé électrochimique selon la revendication 10, dans lequel le procédé comprend en outre une étape consistant à former une couche d'ensemencement métallique sur l'au moins une surface exposée conductrice avant de former le dépôt de cuivre, dans lequel la couche d'ensemencement métallique comprend un matériau choisi parmi le cobalt, le cuivre et le ruthénium ;
dans lequel, éventuellement, la couche d'ensemencement métallique est faite d'au moins deux matériaux choisis dans le groupe constitué de cobalt, cuivre et ruthénium ;
dans lequel, éventuellement et en outre, la couche d'ensemencement métallique comprend une couche de ruthénium et une couche de cuivre ; ou la couche d'ensemencement métallique comprend une couche de cobalt et une couche de cuivre, la couche de cobalt étant déposée sur une couche barrière contre la diffusion.

12. Procédé électrochimique selon la revendication 11, dans lequel la couche d'ensemencement métallique a une épaisseur allant de 1 nm à 10 nm.

13. Procédé électrochimique selon la revendication 10, dans lequel la surface exposée conductrice est une surface de motifs formés dans un substrat diélectrique.

14. Procédé électrochimique selon l'une quelconque des revendications 11 à 13, dans lequel la polarisation de la surface exposée conductrice est effectuée pendant une durée suffisante pour remplir complètement les motifs avec un dépôt de cuivre, dans lequel le pourcentage moyen de vides est de 0 % en volume.

15. Procédé électrochimique selon la revendication 13 ou la revendication 14, dans lequel les motifs ont une dimension d'ouverture qui va de 5 à 45 nm et un facteur de forme qui est supérieur à 2, de préférence qui va de 3 à 10, plus préférablement de 4 à 10.
